Europäisches Patentamt

European Patent Office

Office européen des brevets

(11) Publication number: **0 399 849**
**A2**

## (12) EUROPEAN PATENT APPLICATION

(21) Application number: **90305761.0**

(51) Int. Cl.⁵: **G01B 7/00, H03K 17/945**

(22) Date of filing: **25.05.90**

(30) Priority: **26.05.89 JP 61301/89 U**

(43) Date of publication of application:
**28.11.90 Bulletin 90/48**

(84) Designated Contracting States:
**AT BE CH DE DK ES FR GB GR IT LI NL SE**

(71) Applicant: **OMRON CORPORATION**
**10, Tsuchido-cho, Hanazono, Ukyo-ku,**
**Kyoto-shi, Kyoto-fu(JP)**

(72) Inventor: **Akitsu, Yasushi**
**No. 219 Higashinasaka, Minakuchi-cho**
**Koga-gun, Shiga(JP)**

(74) Representative: **Calderbank, Thomas Roger et**
**al**
**MEWBURN ELLIS 2 Cursitor Street**
**London EC4A 1BQ(GB)**

(54) **Position detection sensor.**

(57) A position detection sensor comprises a casing (2) having a U-shaped portion with facing leg portions (2a,2b); a magneto-electric conversion element (5) located in the casing; and a magnetic member (3,4) at least partially filling an interior chamber of each leg portion (2a,2b) and connecting from the respective leg portion to the magneto-electric conversion element (5), so that a magnetic circuit is formed when a magnet (8) passes between the leg portions.

# FIG. 2

## POSITION DETECTION SENSOR

The present invention relates to a position detection sensor for detecting a position of a magnet.

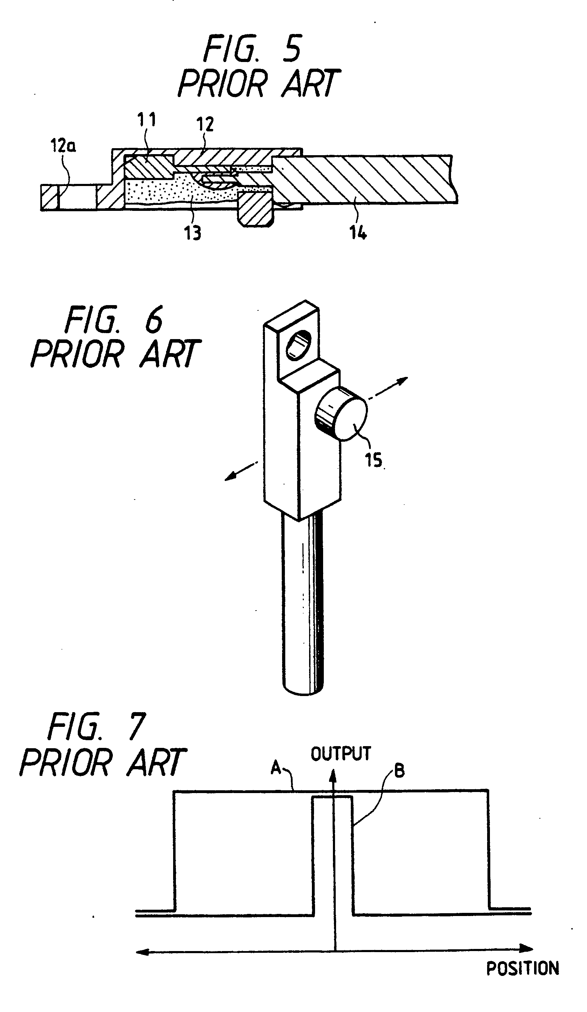

A known position detection sensor for detecting a position of a magnet by use of an magneto-electric conversion IC, such as a Hall element or the like, is shown in the sectional view of Fig. 5 and the perspective view of Fig. 6. This position detection sensor has a structure in which a magneto-electric conversion IC 11 is embedded in a casing 12, and a cord 14 and the magneto-electric conversion IC 11 are connected to each other with epoxy resin 13. The position detection sensor is attached to a predetermined position through an opening 12a formed in one end of the casing 12 so as to detect the position of a magnet 15 passing in the vicinity of the position detection sensor as shown in Fig. 6.

In such conventional position detection sensors, there is the problem that when a magnet passes in the vicinity of the position detection sensor, the sensitivity greatly varies depending on the distance between the magnet 15 and the position detection sensor, as shown by the curves A and B in Fig. 7. A further disadvantage is that the magnetic flux generated by a magnet can not be effectively used, so that the detection distance becomes short or the variations of the detection distance becomes so large in the case where the size of the magnet 15 or the sensitivity of the magneto-electric conversion IC 11 is taken into consideration. Still a further disadvantage is that where another magnetic body is in the vicinity of the position detection sensor, the position detection sensor is greatly affected by the second magnetic body.

The present invention addresses the above-mentioned problems of such conventional position detection sensors by providing a magnetic circuit with a magnetic body.

Accordingly we provide a position detection sensor for detecting a position of a magnet wherein a magneto-electric conversion element is provided in a casing having a U-shaped section and having a top end formed by two protrusions facing each other, and wherein a magnetic member is provided between the magneto-electric conversion element and each of the protrusions of the casing, so that a magnetic circuit is formed by a magnet which passes between the protrusions of the casing.

According to the present invention, magnetic material is provided in the U-shaped formation around the magneto-electric detecting element, so that the magnetic circuit is formed by the U-shaped magnetic member when a magnet is passed between the facing protrusions of the U-shaped magnetic member. Accordingly, the spreading of the magnetic flux of the magnet is less, and the intensity of the magnetic flux passing the magnetic conversion element varies less in dependence on the position of the passing magnet.

The magnetic flux generated by the magnet, according to the present invention, can be effectively used, so that a relatively large detection distance can be obtained even in the case where the magnet is small. Further, the spreading of the magnetic flux can be decreased so that variations of the detection distance can be made small. Additionally, it is possible to reduce the effect of another magnetic body on the position detection sensor even when the magnetic body is in the vicinity of the position detection sensor.

Embodiments are now described by way of example.

Fig. 1 is a perspective view showing an external appearance of an embodiment of the position detection sensor;

Fig. 2 is a vertical sectional view of the same;

Fig. 3 is a graph showing an example of the characteristics of the same;

Fig. 4 is a vertical sectional view of another embodiment of the present invention;

Fig. 5 is a vertical sectional view of a conventional position detection sensor;

Fig. 6 is a perspective view of the same; and

Fig. 7 is a graph showing the sensitivity characteristic of the same.

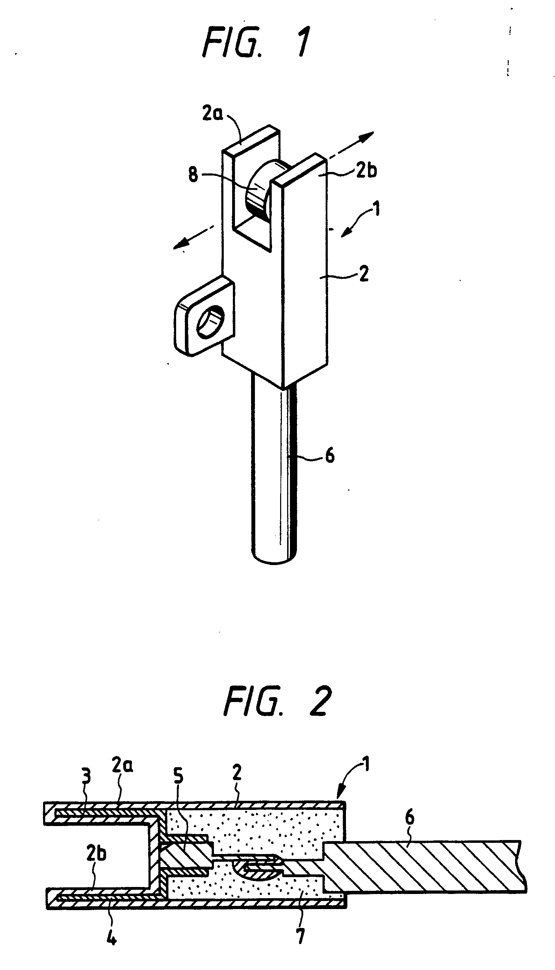

As shown in the drawings, the top end of a position detection sensor 1 has a U-shaped section formed from opposing protrusions 2a and 2b. Plate-like magnetic members 3 and 4 (Fig. 2), each having two bent portions, have one end inserted into the protrusions 2a and 2b, respectively, of a casing 2 of the position detection sensor A magneto-electric conversion IC 5 including a Hall element is provided in a central portion of the casing 2. The magneto-electric conversion IC 5 is a device which amplifies an output of the Hall element and discriminates the amplified output with a predetermined threshold level thereby to provide a switching out. The respective facing surfaces of the base portions of the two magnetic members 3 and 4 abut on the opposite surfaces of the magneto-electric conversion IC 5. Within the casing 2, the magneto-electric conversion IC 5 is connected to a lead wire 6 which is led into the casing 2, and the magneto-electric conversion IC 5 and the lead wire 6 are fixed by use of epoxy resin 7 or the like.

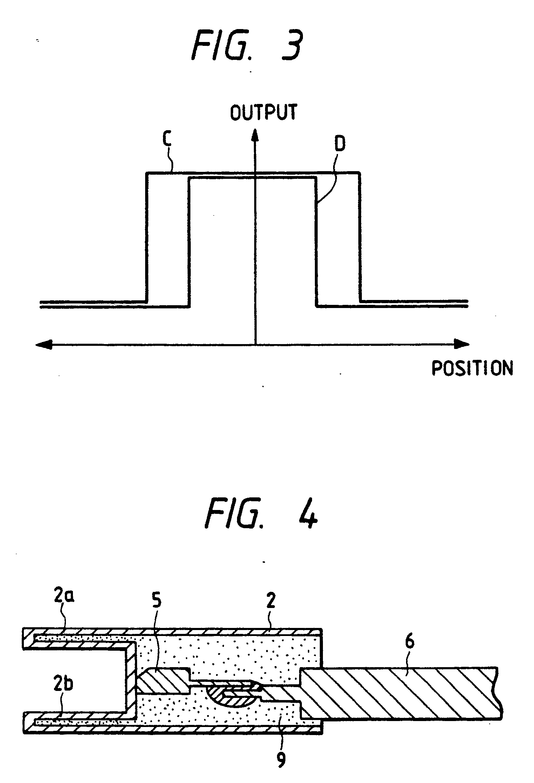

By use of such a position detection sensor, even in the case where the position of a magnet 8 (passing the central portion between the magnetic members 3 and 4, as shown in Fig. 1) fluctuates, the sensitivity of position detection changes less than a conventional position detection sensor as shown by curves C and D in Fig. 3. Accordingly, it is possible to provide a position detection sensor in which the detected position does not fluctuate as much.

Although the shown embodiment has a configuration in which the U-shaped magnetic members 3 and 4 are embedded in the casing 1, the configuration may be modified such that resin, such as epoxy resin 9 or the like in which magnetic powder is mixed, is poured in a casing 1 having a top end of U-shaped protrusions as shown in section in Fig. 4. In this case, similarly, since a magnetic circuit is formed by the magnetic powder, spreading of the magnetic flux of a magnet passing through between the U-shaped protrusions can be decreased so that the position of the magnet can be detected with high sensitivity.

It will be clear to those skilled in the art that the present invention is not limited to the embodiments shown and described.

## Claims

1. A position detection sensor, comprising:
a casing having a U-shaped portion, said U-shaped portion having two facing leg portions;
a magneto-electric conversion element located in said casing; and
a magnetic member at least partially constituting each said leg portion and extending from said respective leg portion to said magneto-electric conversion element, so that a magnetic circuit is formed when a magnet passes between said leg portions.

2. The position detection sensor according to claim 1, wherein each said magnetic member is a plate-like magnet.

3. The position detection sensor according to claim 1, wherein each said magnetic member comprises epoxy resin having magnetic powder mixed therewith.

4. The position detection sensor according to claim 2, further comprising a lead wire connected to said magneto-electric conversion element.

5. The position detection sensor according to claim 4, wherein an interior portion of said casing is filled with epoxy resin.

6. A method of preventing dispersion of magnetic flux of a passing magnet in a position detection sensor, comprising:
providing a casing having a U-shaped portion, said U-shaped porting having two facing leg locating a magneto-electric conversion element in said casing; and
at least partially filling an interior chamber of each said leg portion with a magnetic member, said interior chamber extending from said respective leg portion to said magneto-electric conversion element, so that a magnetic circuit is formed when a magnet passes between said leg portions.

7. A method of detecting the position of a magnet, using a sensor according to any one of claims 1 to 5.

## FIG. 1

## FIG. 2

## FIG. 3

## FIG. 4

# FIG. 5
# PRIOR ART

# FIG. 6
# PRIOR ART

# FIG. 7
# PRIOR ART